# EUROPEAN PATENT APPLICATION

(11) **EP 3 503 219 A1**
(43) Date of publication of application: **26.06.2019**
(21) Application number: 18186533.8
(22) Date of filing: 31.07.2018
(51) Int. Cl.: H01L 31/18, B23K 26/00, B23K 26/02, B23K 26/03, B23K 26/035

(54) **DEVICE FOR WELDING A BUS BAR OF SOLAR CELL**

(30) Priority: 22.12.2017 CN 201711406922
(71) Applicant: Beijing Juntai Innovation Technology Co., Ltd, 100176 Beijing (CN)
(72) Inventor: Guo, Zheng, Beijing, 100176 (CN); Wang, Xudong, Beijing, 100176 (CN); Fan, Huibin, Beijing, 100176 (CN)
(74) Representative: Soria Parra, Manuel

(57) **Abstract**

The present invention discloses a device for welding a bus bar of a solar cell, including a welding platform, a laser, a sensor and a laser adjustment mechanism. The laser is disposed over the welding platform. The laser adjustment mechanism is connected to the laser. The surface of the welding platform is provided with the sensor. In the device for welding a bus bar of a solar cell according to the present invention, laser welding is employed instead of the conventional manual soldering iron welding and resistance heating welding, and the power of the laser can be adjusted as desired with the laser adjustment mechanism, thereby better controlling the accuracy and uniformity of the welding temperature of the bus bar. Compared with the related art, it can improve the welding quality of the bus bar, avoid the positional deviation between the bus bar and the drain bar, reduce the bad phenomenon such as the false welding or the missing welding and improve the overall performance of the photovoltaic module.

## Description

### TECHNICAL FIELD

The present invention relates to the technical field of manufacturing high-efficiency heterojunction solar cell modules, in particular to a device for welding a bus bar of a solar cell.

### BACKGROUND

Photovoltaic power generation, as a recognized clean energy, has a wider range of applications. Moreover, photovoltaic power generation has been continuously supported by national policies. Welding of a bus bar is one of the indispensable processes in a packaging process of a solar cell module. In a conventional bus-bar welding process, manual soldering iron welding or resistance heating welding is generally employed.

For the manual soldering iron welding, it is difficult to ensure the consistency of the welding quality. Meanwhile, for the resistance heating contact welding, the accuracy of the heating temperature control may be poor, and contact welding may easily lead to positional deviation between a drain bar and a bus bar, causing false welding, missing welding and other issues.

Therefore, it is necessary to provide a device for welding a bus bar of a solar cell to mitigate the above issues.

### SUMMARY

An object of the present invention is to provide a device for welding a bus bar of a solar cell, which solves the problems in the related art that manual soldering iron welding and resistance heating welding have poor accuracy and that positional deviation between the bus bar and the drain bar easily occurs. In the device for welding a bus bar of a solar cell according to the present invention, laser welding is employed instead of the conventional welding. It can avoid the positional deviation between the bus bar and the drain bar, improve the welding quality of the bus bar, and reduce the bad phenomenon such as the false welding or the missing welding.

In order to achieve the above object, the present invention provides the following technical solutions.

A device for welding a bus bar of a solar cell includes a welding platform, a laser, a sensor and a laser adjustment mechanism, wherein the laser is disposed over the welding platform, the laser adjustment mechanism is connected to the laser, and the surface of the welding platform is provided with the sensor.

Preferably, the device for welding a bus bar of a solar cell further includes a driving apparatus and a moving mechanism, wherein the driving apparatus is connected to the moving mechanism and drives the moving mechanism, and the laser is connected to the moving mechanism.

Preferably, the device for welding a bus bar of a solar cell further includes an angle adjustment mechanism and a movable arm, wherein the angle adjustment mechanism is connected to an end of the welding platform and a suction cup is provided at an end of the movable arm.

Preferably, the welding platform is provided with a welding area and a non-welding area, the sensor includes a temperature sensor and a pressure sensor, and both of the pressure sensor and the temperature sensor are disposed in the welding area.

Preferably, the device for welding a bus bar of a solar cell further includes a distance sensor disposed on a laser head of the laser.

Preferably, the device for welding a bus bar of a solar cell further includes a conveying apparatus, and a lifting apparatus disposed below the conveying apparatus.

Preferably, a heat insulation plate is provided on the welding platform.

Preferably, a slippery prevention area is provided on the welding platform.

Preferably, a cleaning apparatus is provided on the welding platform.

Preferably, the laser is a fiber laser, and the fiber laser can project multiple laser beams at the same time.

The beneficial effects of the present invention are as follows.

The present invention provides a device for welding a bus bar of a solar cell including a welding platform, a laser, a sensor and a laser adjustment mechanism. The laser is disposed over the welding platform. The laser adjustment mechanism is connected to the laser. The surface of the welding platform is provided with the sensor. In the device for welding a bus bar of a solar cell according to the present invention, laser welding is employed instead of the conventional manual soldering iron welding and resistance heating welding, and the power of the laser can be adjusted as desired with the laser adjustment mechanism, thereby better controlling the accuracy and uniformity of the welding temperature of the bus bar. Compared with the related art, it can improve the welding quality of the bus bar, avoid the positional deviation between the bus bar and the drain bar, reduce the bad phenomenon such as the false welding or the missing welding and improve the overall performance of the photovoltaic module.

### BRIEF DESCRIPTION OF THE DRAWINGS

Fig. 1 is a front view of a device for welding a bus bar of a solar cell according to an embodiment of the present invention;
Fig. 2 is a left side view of a device for welding a bus bar of a solar cell according to an embodiment of the present invention;
Fig. 3 is a schematic view of a first partial structure of a device for welding a bus bar of a solar cell according to an embodiment of the present invention;
Fig. 4 is a schematic diagram of a second partial structure of a device for welding a bus bar of a solar cell according to an embodiment of the present invention.

### Reference Numerals:

1-welding platform, 2-laser, 3-laser head, 4-bus bar, 5-drain bar, 6-front panel glass, 7-laser beam.

### DETAILED DESCRIPTION

The embodiments described below with reference to the drawings are exemplary, and serve to only explain the present invention, but cannot be construed as limiting the present invention.

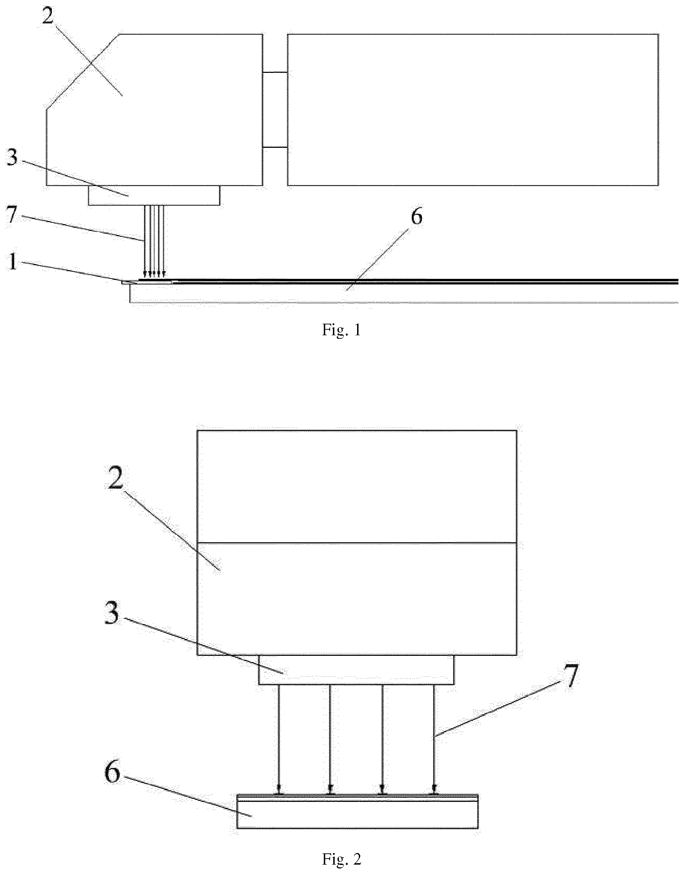

As shown in Fig. 1 and Fig. 2, an embodiment of the present invention provides a device for welding a bus bar of a solar cell. The device includes a welding platform 1, a laser 2, a sensor, and a laser adjustment mechanism. The laser 2 is disposed over the welding platform 1. The laser adjustment mechanism is connected to the laser 2, and the surface of the welding platform 1 is provided with the sensor. The welding platform 1 is preferably made of a non-metal material such as Teflon.

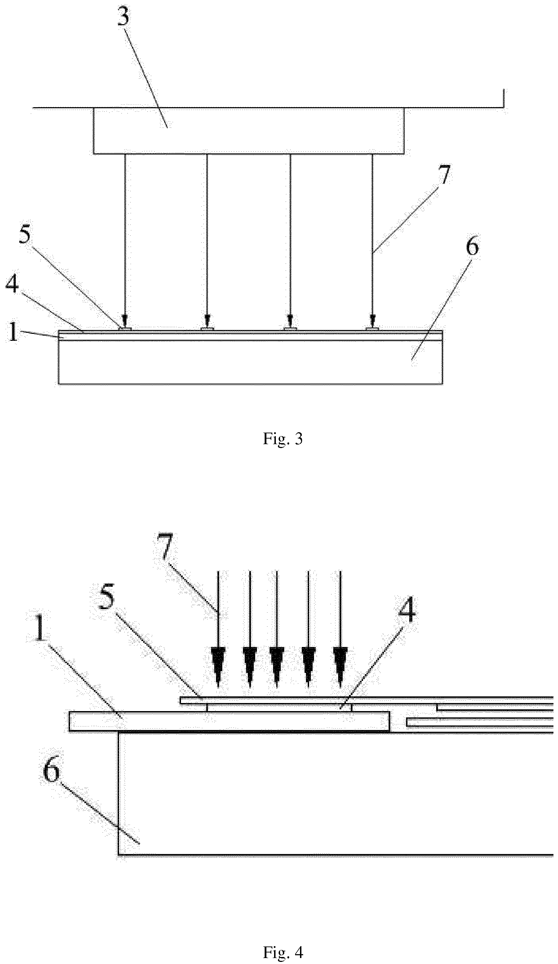

The device according to the present invention is operated as follows. As shown in Fig. 3 and Fig. 4, a bus bar 4 is firstly placed on the welding platform 1, and then a drain bar 5 of a solar cell string is placed on the bus bar 4. After that, the laser 2 is turned on, and the laser 2 performs non-contact heating melt welding on the drain bar 5 and the bus bar 4 with a laser beam 7 of ultra-high energy density. During this process, the power of the laser 2 may also be adjusted by the laser adjustment mechanism, and in turn, the intensity of the laser beam 7 is adjusted, in order to adapt to different welding requirements. It may be seen from the above operation steps, in the device for welding a bus bar of a solar cell according to the present invention, laser welding is employed instead of the conventional manual soldering iron welding and resistance heating welding, and the power of the laser 2 can be adjusted as desired with the laser adjustment mechanism. It can better control the accuracy and uniformity of the welding temperature of the bus bar 4, and improve the welding quality of the bus bar 4. In addition, it can accomplish welding without requiring the laser 2 to be in direct contact with the bus bar 4 and the drain bar 5, so that the positional deviation between the bus bar 4 and the drain bar 5 can be avoided, the bad phenomenon such as the false welding or the missing welding can be reduced and the overall performance of the photovoltaic module can be improved.

Based on the above structure, the device for welding a bus bar of a solar cell according to an embodiment of the present invention further preferably includes a driving apparatus and a moving mechanism. The driving apparatus is connected to the moving mechanism and drives the moving mechanism. The laser 2 is connected to the moving mechanism. The moving mechanism is preferably a mechanism that may move both horizontally and vertically, so as to drive the laser 2 to form a variety of welding paths to better meet the personalized demands of users.

In addition, the device for welding a bus bar of a solar cell according to the present invention also preferably includes an angle adjustment mechanism and a movable arm. The angle adjustment mechanism is connected to an end of the welding platform 1, and an end of the movable arm is provided with a suction cup. The angle adjustment mechanism and the movable arm are preferably disposed on both sides of the welding platform 1. As shown in Fig. 4, in the practical welding process, the bus bar 4 does not exist alone, but is connected to a front panel glass 6. In this case, when placing the bus bar 4 on the welding platform 1, it requires firstly sucking up the drain bar 5 by means of the suction cup of the movable arm. Then, the welding platform 1 is turned over by an angle with the use of the angle adjustment mechanism, to adapt to the gap between the bus bar 4 and the front panel glass 6, and the welding platform 1 is placed in the gap. Next, the assembled welding platform 1, bus bar 4 and front panel glass 6 are placed horizontally, and the drain bar 5 is placed on the bus bar 4 through the suction cup of the movable arm. Thereby, the preliminary preparation work for welding is completed.

Further, the welding platform 1 is provided with a welding area and a non-welding area. The sensor includes a temperature sensor and a pressure sensor. The pressure sensor and the temperature sensor are both disposed in the welding area. The temperature sensor is preferably disposed at a position corresponding to a welding point of the drain bar 5 and the bus bar 4, and functions to detect the temperature at the welding point in real time. When the temperature sensor detects that the temperature at the welding point is low, the temperature sensor transmits the signal to the controller, and the controller controls the laser adjustment mechanism to increase the power of the laser 2, and in turn, to increase the intensity of the laser beam 7, so as to increase the temperature at the welding point. On the contrary, the laser adjustment mechanism reduces the power of the laser 2, to reduce the intensity of the laser beam 7, so as to reduce the temperature at the welding point. The pressure sensor is preferably arranged below the placement area of the bus bar 4, mainly to determine whether the bus bar 4 and the drain bar 5 are placed on the welding platform 1 according to the detected pressure. After the bus bar 4 and the drain bar 5 are placed on the welding platform 1, the signal is transmitted to the controller, and the laser 2 is started by the controller for welding.

In order to improve the welding accuracy of the bus bar 4 and the drain bar 5, the device for welding a bus bar of a solar cell according to an embodiment of the present invention preferably further includes a distance sensor provided on a laser head 3 of the laser 2. The distance sensor is preferably parallel to the axis of the laser head 3 and perpendicular to the bus bar 4 and the drain bar 5. On the one hand, the distance sensor may also detect whether the bus bar 4 and the drain bar 5 are placed in the welding area so as to provide reference information for the starting of the laser 2. On the other hand, it is also possible to determine the precise placement area of the bus bar 4 and the drain bar 5 through the detection result, and adjust the position of the laser head 3 of the laser 2 according to the positions of the bus bar 4 and the drain bar 5 so as to better adapt to welding.

In order to improve work efficiency, save human labor cost and improve the automation and intelligence of the overall device, the device for welding a bus bar of a solar cell also includes a conveying apparatus with a lifting apparatus disposed below the conveying apparatus. With the lifting apparatus, the height of the conveying apparatus may be adjusted to facilitate the fitting of the bus bar 4 and the drain bar 5 with the welding platform 1.

Preferably, the welding platform 1 is provided with a heat insulation plate thereon. With the heat insulation plate, the laser beam 7 may be prevented from melting the EVA film on the front panel glass 6.

Further, the welding platform 1 is provided with a slippery prevention area thereon. In this slippery prevention area, slippery prevention can be achieved by providing slippery prevention particles or slippery prevention ripples. The slippery prevention area can further reduce the probability of positional deviation between the bus bar 4 and the drain bar 5.

In addition, the welding platform 1 is further preferably provided with a cleaning apparatus thereon. With the cleaning apparatus, impurities on the welding platform 1 can be removed, the good cooperation between the bus bar 4 and the welding platform 1 can be ensured, and in turn, the welding quality of the bus bar 4 and the drain bar 5 can be ensured.

Specifically, the laser 2 is a fiber laser. The fiber laser may project multiple laser beams 7 at the same time. These laser beams 7 are parallel to each other, and the distance between adjacent laser beams 7 may be adjusted according to a distance from the welding point, to improve the welding efficiency. As shown in Fig. 2 and Fig. 3, the laser 2 may project four laser beams at the same time, and weld four positions of the bus bar 4 and the drain bar 5.

The structure, features, and effects of the present invention have been described in detail with reference to the embodiments shown in the drawings. The above description is only preferred embodiments of the present invention, but the present invention does not limit the scope of implementation as shown in the drawings. Any modifications made to the conception of the present invention, or equivalent embodiments that are modified to equivalent variations, should still fall within the protection scope of the present invention and not go beyond the scope covered by the description and the drawings.

## Claims

1. A device for welding a bus bar of a solar cell, comprising a welding platform (1), a laser (2), a sensor and a laser adjustment mechanism, wherein the laser (2) is disposed over the welding platform (1), the laser adjustment mechanism is connected to the laser (2), and the surface of the welding platform (1) is provided with the sensor.

2. The device for welding a bus bar of a solar cell according to claim 1, further comprising a driving apparatus and a moving mechanism, wherein the driving apparatus is connected to the moving mechanism and drives the moving mechanism, and the laser (2) is connected to the moving mechanism.

3. The device for welding a bus bar of a solar cell according to claim 1 or 2, further comprising an angle adjustment mechanism and a movable arm, wherein the angle adjustment mechanism is connected to an end of the welding platform (1) and a suction cup is provided at an end of the movable arm.

4. The device for welding a bus bar of a solar cell according to one of the preceding claims, wherein the welding platform (1) is provided with a welding area and a non-welding area, the sensor comprises a temperature sensor and a pressure sensor, and both of the pressure sensor and the temperature sensor are disposed in the welding area.

5. The device for welding a bus bar of a solar cell according to one of the preceding claims, further comprising a distance sensor disposed on a laser head (3) of the laser (2).

6. The device for welding a bus bar of a solar cell according to one of the preceding claims, further comprising a conveying apparatus, and a lifting apparatus disposed below the conveying apparatus.

7. The device for welding a bus bar of a solar cell according to one of the preceding claims, wherein a heat insulation plate is provided on the welding platform (1).

8. The device for welding a bus bar of a solar cell according to one of the preceding claims, wherein a slippery prevention area is provided on the welding platform (1).

9. The device for welding a bus bar of a solar cell according to one of the preceding claims, wherein a cleaning apparatus is provided on the welding platform (1).

10. The device for welding a bus bar of a solar cell according to one of the preceding claims, wherein the laser (2) is a fiber laser, and the fiber laser can project multiple laser beams (7) at the same time.
